**Europäisches Patentamt**

**European Patent Office**

**Office européen des brevets**

(11) Veröffentlichungsnummer: **0 651 515 A1**

## (12) EUROPÄISCHE PATENTANMELDUNG

(21) Anmeldenummer: **94111288.0**

(22) Anmeldetag: **20.07.94**

(51) Int. Cl.⁶: **H03L 3/00**

(30) Priorität: **28.10.93 DE 4337536**

(43) Veröffentlichungstag der Anmeldung:
**03.05.95 Patentblatt 95/18**

(84) Benannte Vertragsstaaten:
**DE DK ES FR IT**

(71) Anmelder: **DeTeWe FUNKWERK KOPENICK GmbH
Wendenschlossstrasse 142
D-12557 Berlin (DE)**

(72) Erfinder: **Drescher, Jürgen
Zur Nachtheide 56
D-12557 Berlin (DE)**

(54) Schaltungsanordnung für eine Anschwinghilfe eines Transistor-Oszillators.

(57) Für einen Transistor-Oszillator mit im Verstärkerausgang liegendem Stromgegenkopplungswiderstand wird eine Anschwinghilfe vorgeschlagen, die aus einem Schalttransistor (T2) mit einem Kondensator (C3) und einem Widerstand (R1) besteht, die parallel zum Stromgegenkopplungswiderstand geschaltet sind.

FIG. 3

EP 0 651 515 A1

Die Erfindung betrifft eine Schaltungsanordnung für eine Anschwinghilfe eines Transistor-Oszillators, an dessen Verstärkerausgang ein Stromgegenkopplungswiderstand geschaltet ist.

Das Anschwingen eines Oszillators oder Generators geschieht in der Weise, daß beim Anlegen der Speisespannung ein Stromstoß entsteht, der alle Resonanzfrequenzen enthält. Durch einen Verstärker wird die Resonanzfrequenz verstärkt und mit richtiger Phasenlage auf den Eingang rückgekoppelt, wieder verstärkt, wieder rückgekoppelt usw.

In Empfangseinrichtungen, z. B. Empfangseinrichtungen für Funkrundsteuerungen, ist es notwendig, Oszillatorschaltungen sehr schnell anschwingen zu lassen. Insbesondere nach Netzspannungs-Unterbrechungen ist ein schnelles Anschwingen erforderlich.

Weiterhin ist eine Anschwinghilfe erforderlich, wenn die Oszillatorschaltung nur geringe Verzerrungen erzeugen darf und der Quarzwiderstand groß ist und einen großen Toleranzbereich aufweist. Geringe Verzerrungen werden erreicht, indem die Oszillatorschaltung in der Nähe der Anfachungsbedingungen schwingt.

Für Kristalloszillatoren sind Anschwinghilfen bekannt, bei denen ein Kristall parallel zu einem Verstärkungsinverter geschaltet ist, an dessen Ein- und Ausgang außerdem geerdete Kondensatoren liegen (DE-37 34 146 A1).

Eine andere Schaltungsanordnung setzt einen zusätzlichen Verstärker ein, dessen Ausgang über einen Kondensator und einem in Reihe liegenden Widerstand an den Eingang des Verstärkers des Oszillators geschaltet ist (DE-31 45 653 A1).

Der Erfindung lag die Aufgabe zugrunde, für einen Transistor-Oszillator eine Anschwinghilfe geringen wirtschaftlichen Aufwandes anzugeben.

Diese Aufgabe ist durch die Erfindung gelöst, wie sie im Kennzeichnungsteil des Patentanspruches dargelegt ist.

Anhand einer aus drei Figuren bestehenden Zeichnung wird die Erfindung näher erläutert. In der Zeichnung zeigen die

Fig. 1 das Blockschaltbild eines Oszillators, die
Fig. 2 die Schaltung eines Oszillators und die
Fig. 3 eine Oszillatorschaltung mit Anschwinghilfe.

In allen Figuren tragen gleiche Bauelemente dieselben Bezugszeichen.

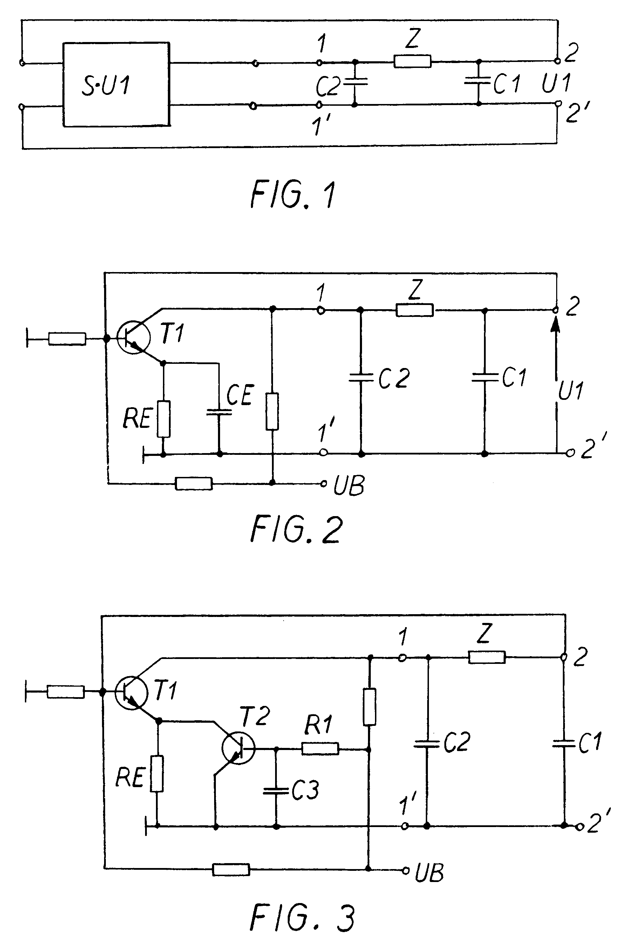

Bei einem Oszillator gemäß Figur 1 ist zwischen den Klemmen 2 und 2' eine Spannung U1 wirksam. Damit wird an den Klemmen 1 und 1' eine Einströmung von S • U1 erzeugt, worin S die Steilheit der Verstärkerstufe ist. Die Oszillatorschaltung ist schwingfähig, wenn die von dieser Einströmung S • U1 erzeugte Spannung an den Klemmen 2 und 2' wieder gleich U1 ist. Als Rückkopplungsglied sind ein komplexer Widerstand Z und die Kondensatoren C1 und C2 vorgesehen. Der komplexe Widerstand Z kann ein Scwingkreis oder ein Schwingquarz sein. Für die praktische Dimensionierung einer Oszillatorschaltung gilt für die Schwinganfachungsbedingung

$$C_k = \frac{1}{2\,\omega}\sqrt{\frac{S}{Rq}} \qquad [1]$$

worin der Quarzwiderstand Rq Bestandteil des komplexen Widerstandes Z ist, S die Steilheit der Verstärkerstufe und ω die Schwingkreisfrequenz. Für die Kapazität C1, C2 gilt

$$C_k = \frac{C1 \cdot C2}{C1 + C2} \qquad [2]$$

Einem solchen Quarzoszillator entspricht ein Schaltungsaufbau für einen Transistor-Oszillator gemäß der Figur 2. Darin besteht die Verstärkerstufe aus dem Verstärkertransistor T1 mit einem Stromgegenkopplungswiderstand RE. Damit der Stromgegenkopplungswiderstand RE den Arbeitspunkt des Verstärkertransistors T1 stabilisiert und keine Gegenkopplung der Eingangswechselspannung bewirkt, ist ihm ein Kondensator CE parallel geschaltet.

Um die Schwinganfachungsbedingungen einer solchen Oszillatorschaltung mit großer Sicherheit zu erfüllen und ein schnelles Anschwingen zu gewährleisten, wird erfindungsgemäß anstelle des Kondensators CE am Emitter des Verstärkertransistors T1 ein Schalttransistor T2 mit seiner Basis über einen Widerstand R1 an die Betriebsspannung UB und über einen Kondensator C3 an die Schaltungsmasse gelegt (Figur 3). Der Emitter des Schalttransistors T2 wird ebenfalls an die Schaltungsmasse gelegt, während der Kollektor mit dem Emitter des Verstärkertransistors T1 verbunden ist. Als Verstärkertransistors T1 ist ein Transistor gewählt, der eine für die Schwingfrequenz des Oszillators große Steilheit S aufweist. Durch die Stromgegenkopplung mittels des Stromgegenkopplungswiderstandes RE werden die Transistorparameter des Verstärkertransistors T1 stabilisiert. Die wirksame Steilheit der Verstärkerstufe wird jedoch um einen Faktor k < 1 reduziert. Somit beträgt die wirksame Steilheit des Verstärkers

$$S' = S \cdot k \qquad [3]$$

Mit dieser wirksamen Steilheit S' und der Gleichung [1] wird die Oszillatorschaltung nach Figur 3 dimensioniert.

Tritt nach dem Einschalten der Betriebsspannung UB am Basisanschluß des Schalttransistors T2 ein Spannungsimpuls auf, so wird der Stromgegenkopplungswiderstand RE für die Zeit T $\approx$ C3 $\cdot$ R1 kurzgeschlossen. Dieser Kurzschluß bewirkt eine Erhöhung des Kollektorstromes des Verstärkertransistors T1 und damit eine Erhöhung der Steilheit S. Mit der Erhöhung der Steilheit S wird demzufolge die Schwinganfachungsbedingung gemäß Gleichung [1] mit großer Sicherheit erfüllt und der Oszillator schwingt schnell an.

**Patentansprüche**

1.  Schaltungsanordnung für eine Anschwinghilfe eines Transistor-Oszillators, an dessen Verstärkerausgang ein Stromgegenkopplungswiderstand geschaltet ist, dadurch gekennzeichnet, daß parallel zum Stromgegenkopplungswiderstand (RE) ein Schalttransistor (T2) mit seinem Kollektor an den Emitteranschluß des Verstärkertransistors (T1) und seinem Emitter an die Schaltungsmasse gelegt und daß der Basisanschluß des Schalttransistors (T2) über einen Kondensator (C3) an Schaltungsmasse und über einen Widerstand (R1) an die Betriebsspannung (UB) geschaltet ist.

FIG. 1

FIG. 2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US-A-4 282 496 (R.C. HEUNER) * Spalte 1, Zeile 22 - Spalte 3, Zeile 58; Abbildung 1 * | 1 | H03L3/00 |
| | --- | | |
| A | US-A-4 274 066 (A. YOSHISATO ET AL.) * Spalte 3, Zeile 48 - Spalte 4, Zeile 31; Abbildungen 5,6 * | 1 | |
| | ----- | | |

**RECHERCHIERTE SACHGEBIETE (Int.Cl.6)**

H03L

Der vorliegende Recherchenbericht wurde für alle Patentansprüche erstellt

| Recherchenort | Abschlußdatum der Recherche | Prüfer |
|---|---|---|
| DEN HAAG | 3. Februar 1995 | Dhondt, I |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)